# EUROPEAN PATENT APPLICATION

(11) **EP 1 059 661 A2**
(43) Date of publication of application: **13.12.2000**
(21) Application number: 00111392.7
(22) Date of filing: 26.05.2000
(51) Int. Cl.: H01L 21/20

(54) **Crack-free epitaxial semiconductor layer formed by lateral growth**

(30) Priority: 07.06.1999 US 327129
(71) Applicant: Agilent Technologies Inc, Palo Alto, CA 94306-2024 (US)
(72) Inventor: Chen, Yong, Palo Alto, California 94306 (US); Wang, Shih-Yuan, Palo Alto, California 94306 (US)
(74) Representative: Liesegang, Eva

(57) **Abstract**

An epitaxial material (55) grown laterally from a surface (56a, 56b) formed in a first epitaxial material (52) having a different lattice parameter allows for the formation of epitaxial material (55) that includes a region (60) that is substantially free of cracks (17). Growing a second epitaxial material (55) from a side wall (56a, 56b) of a trench (57) formed in a first epitaxial material (52) having a different lattice parameter rotates the growth direction of the second epitaxial material (55) through approximately 90° with respect to the major surface (63) of the first epitaxial material (52). In this manner, cracks (17) that occur in the second epitaxial material (55) tend to occur in the direction perpendicular to the side wall (56a, 56b) from which the second epitaxial growth initiates, which direction is also parallel to the major surface (63) of the first epitaxial material (52). This results in a substantially crack-free epitaxial material (60) growing out of the trench (57). The substantially crack-free epitaxial material (60) may by used as a platform from which to grow successive epitaxial layers.

## Description

### FIELD OF THE INVENTION

The invention relates generally to the fabrication of semiconductor materials, and, more particularly, to a new fabrication method for growing epitaxial material laterally from a side wall of a trench, the material eventually growing out of the trench and including a crack-free region.

### BACKGROUND OF THE INVENTION

A building block of many electronic devices such as diodes, transistors, and lasers is semiconductor material that can be grown over a substrate. The semiconductor material is fabricated by growing an epitaxial layer of the seimconductor material upon a substrate. The substrate may be, and frequently is, of a different composition and lattice parameter than the material of the epitaxial layer.

It is desirable for the epitaxial layer to be a thin single-crystal film that is grown upon a single crystal substrate. However, in practice, often it is necessary to grow, over the first epitaxial layer, a second epitaxial layer of a different material and having a different lattice parameter than the first epitaxial layer. When there is a significant mismatch between the lattice parameter of the first epitaxial material and the second epitaxial material (as occurs for example when depositing a layer of aluminum galluim nitride (AlGaN) over a layer of gallium nitride (GaN) during the manufacture of a semiconductor laser), a large number of cracks in the AlGaN layer can result due to strain in the second epitaxial layer caused by the lattice mismatch between the AlGaN and the GaN.

Cracks in the AlGaN layer typically extend perpendicular to the major surface of the epitaxial layer and can result in unacceptably high optical loss, low optical efficiency, non-uniform quantum wells in the active region, and the reduction of the electrical quality of the material. These conditions prevent the material from being used to fabricate certain devices, such as lasers and transistor structures. A largely crack-free material is desired for these highly critical devices.

Cracks are typical when any epitaxial layer is grown over a material having a lattice parameter different than that of the epitaxial layer. For example, the lattice parameters of GaN are a=3.189, c=5.182, while the lattice parameters of AlN are a=3.111, c=4.980, yielding a lattice mismatch between GaN and AlN of approximately 13.2%. To illustrate, the lattice mismatch between AlxGa₁₋ₓN and GaN is between 0 and 13.2%, depending upon the value of x.

Cracks resulting from this lattice mismatch may result in material that is unusable for semiconductor optical and electrical device fabrication.

Thus, an unaddressed need exists in the industry for a simplified method for growing high quality, crack-free epitaxial material, over a lattice mismatched substrate.

### SUMMARY OF THE INVENTION

The invention provides an epitaxial material that includes a region that is substantially free of cracks perpendicular to the major surface of the epitaxial layer and a method for producing same. Although not limited to these particular applications, the material and method for producing it are particularly suited for fabrication of high quality epitaxial layers of a GaN material. The GaN material can include members of the Group III-V family including, but not limited to, gallium nitride (GaN), indium gallium nitride (InGaN), indium nitride (InN), aluminum gallium nitride (AlGaN), aluminum nitride (AlN), aluminum indium gallium nitride (AlInGaN), gallium arsenide nitride (GaAsN), indium gallium arsenide nitride (InGaAsN), aluminum gallium arsenide nitride (AlGaAsN), gallium phosphide nitride (GaPN), indium gallium phosphide nitride (InGaPN), aluminum gallium phosphide nitride (AlGaPN), *etc*.

The invention can be conceptualized as a method for reducing cracks in an epitaxial growth layer, comprising the steps of: growing a first epitaxial layer of a first material, the epitaxial layer having a major surface; forming, in the first material, a surface substantially perpendicular to the epitaxial major surface; applying a mask to the first epitaxial layer major surface leaving the substantially perpendicular surface unmasked; and laterally growing from the substantially perpendicular surface a second epitaxial layer of a material different from the first material.

In architecture, when employed in connection with the fabrication of an epitaxial layer having a region that is substantially free of cracks perpendicular to a major surface of the epitaxial layer, the above-mentioned method for reducing cracks in an epitaxial growth layer results in a material having a substantially crack-free region as follows.

An epitaxial material comprises a first epitaxial layer of a first material, the first epitaxial layer having a major surface and including a surface substantially perpendicular to the major surface; a mask covering the major surface of the first epitaxial layer, but Leaving the substantially perpendicular surface exposed; and a second epitaxial layer of a second material, the second epitaxial layer extending from the substantially perpendicular surface of the first epitaxial layer and including cracks that extend parallel to the major surface of the first epitaxial layer and are localized to the vicinity of the substantially perpendicular surface.

The invention has numerous advantages, a few which are delineated below merely as examples.

An advantage of the invention is that it increases the yield of high quality, substantially crack-free epitaxial material in an epitaxial layer grown over an epitaxial layer of a different material.

Another advantage of the invention is that it reduces the amount of optical loss in the epitaxial layer of a semiconductor material.

Another advantage of the invention is that it increases the optical efficiency in the epitaxial layer of a semiconductor device.

Another advantage of the invention is that it improves the optical performance of the material forming the epitaxial layer of a semiconductor device.

Another advantage of the invention is that it is simple in design and easily implemented on a mass scale for commercial production.

Other features and advantages of the invention will become apparent to one with skill in the art upon examination of the following drawings and detailed description. These additional features and advantages are intended to be included herein within the scope of the invention.

### BRIEF DESCRIPTION OF THE DRAWINGS

The invention, as defined in the claims, can be better understood with reference to the following drawings. The components within the drawings are not necessarily to scale relative to each other, emphasis instead being placed upon clearly illustrating the principles of the invention.
Fig. 1A is a cross-sectional schematic view illustrating the cracks that tend to occur in an epitaxial growth layer in a direction perpendicular to the major surface of another epitaxial growth layer when it is grown over a material having a different lattice parameter;
Fig. 1B is a plan view of the epitaxial AlGaN layer of Fig. 1A;
Fig. 2A is a cross-sectional schematic view illustrating the growth progression of the epitaxial material of the invention
Fig. 2B is a cross-sectional schematic view of continued epitaxial growth in accordance with the invention;
Fig. 2C is a cross-sectional schematic view illustrating the further growth progression of AlGaN second epitaxial layer of Fig. 2B;
Fig. 2D is a cross-sectional schematic view illustrating the crack-free region in the AlGaN second epitaxial layer in accordance with the invention;
Fig. 2E is a cross-sectional schematic view illustrating a simplified laser structure including the epitaxial layers grown over the AlGaN second epitaxial layer of Fig. 2D;
Fig. 3 is a cross-sectional schematic view illustrating an alternative embodiment of the trench of Fig. 2A;
Fig. 4A is a cross-sectional schematic view illustrating a plurality of trenches of Figs. 2A-2E; and
Fig. 4B is a cross-sectional schematic view illustrating an alternative embodiment of the trenches of the invention.

### DETAILED DESCRIPTION OF THE PREFERRED EMBODIMENT

The invention can be implemented using a variety of substrate and epitaxial growth materials. While applicable to a variety of materials where the cracks tend to propagate along a particular growth direction, the preferred embodiment of the invention is particularly useful for growing an epitaxial layer of one gallium nitride (GaN) material over another GaN material having a different lattice constant. GaN material can include members of the Group III-V family including, but not limited to, gallium nitride (GaN), indium gallium nitride (InGaN), indium nitride (InN), aluminum gallium nitride (AlGaN), aluminum nitride (AlN), aluminum gallium nitride (AlGaN), aluminum indium gallium nitride (AlInGaN), gallium arsenide nitride (GaAsN), indium gallium arsenide nitride (InGaAsN), aluminum gallium arsenide nitride (AlGaAsN), gallium phosphide nitride (GaPN), indium gallium phosphide nitride (InGaPN), aluminum gallium phosphide nitride (AlGaPN), *etc*. The concepts and features of the invention are applicable to epitaxial layers of other materials and to other substrate materials.

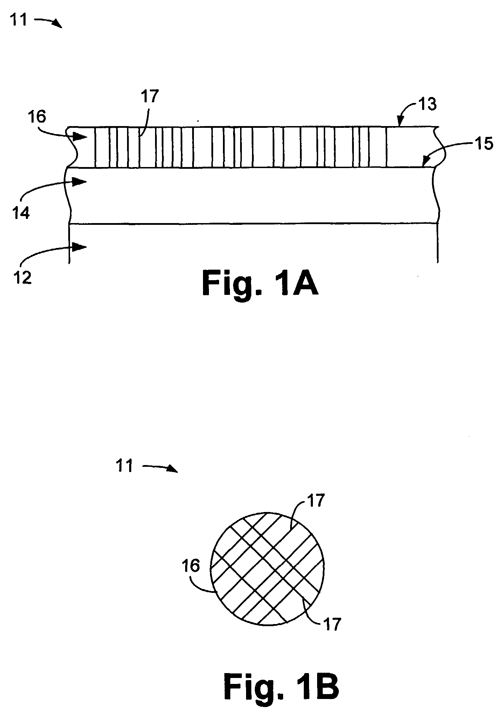

Turning now to the drawings, Fig. 1A illustrates the cracks that tend to occur in a layer when it is epitaxially grown over a material having different lattice parameters using conventional epitaxial growth techniques. In the following detailed description, a first epitaxial layer of high quality gallium nitride is grown over a suitable substrate. The substrate may be sapphire, however, other substrate materials are contemplated by the invention. A second layer of AlGaN is then grown over the first epitaxial GaN layer. The material of the second epitaxial layer has a lattice parameter different than that of the first epitaxial layer. While the preferred embodiment will illustrate an AlGaN epitaxial layer grown over a GaN epitaxial layer, the layers may be any epitaxial layers.

Over sapphire substrate 12 is grown a first epitaxial layer of gallium nitride (GaN) 14. The epitaxial layer 14 is grown over sapphire substrate 12 in a manner known to those skilled in the art.

Over epitaxial GaN layer 14 is grown a second epitaxial layer of aluminum gallium nitride (AlGaN) 16. When fabricating lasers and other electro-optical devices, it is often desirable to grow an AlGaN layer over a GaN layer to create cladding layers, which provide optical confinement and carrier confinement for edge-emitting lasers as known to those sidled in the art. This carrier confinement and optical confinement is achieved because GaN layer 14 has a smaller bandgap than AlGaN layer 16. The optical confinement is achieved because the GaN layer has a smaller refractive index than the AlGaN layer. However, a lattice mismatch exists between epitaxial GaN layer 14 and epitaxial AlGaN layer 16.

The lattice mismatch between the two above-mentioned epitaxial layers gives rise to cracks 17 appearing in epitaxial AlGaN layer 16. When the AlGaN layer 16 is conventionally grown, cracks 17 propagate in a direction perpendicular to the major surface 13 of second epitaxial AlGaN layer 16 as it grows up from first epitaxial GaN layer 14. These cracks 17 are a result of tensile strain, caused by the above-mentioned lattice mismatch, being imparted to the AlGaN layer 16 as it grows in a growth direction perpendicular to the major surface 15 of the GaN layer 14.

To illustrate the lattice mismatch between epitaxial GaN layer 14 and epitaxial AlGaN layer 16, consider that the lattice parameters of GaN are a = 3.189, c = 5.182, while the lattice parameters of aluminum nitride (AlN) are a = 3.111, c = 4.980. This gives rise to a lattice mismatch between GaN and AlN of approximately 13.2%. The lattice mismatch between AlₓGa₁₋ₓN and GaN is approximately equal to 13.2% times x.

Fig. 1B is a plan view of epitaxial AlGaN layer 16 of Fig. 1A. As illustrated, cracks 17 are formed throughout epitaxial AlGaN layer 16, thus diminishing the quality of AlGaN layer 16 such that the layer would exhibit an unacceptably high scattering loss during laser operation.

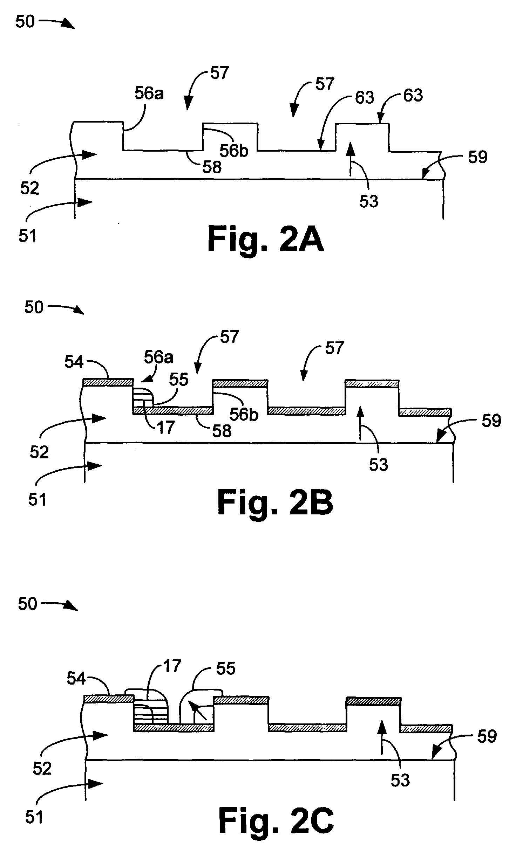

Fig. 2A illustrates the first step of the method of the invention and shows the growth progression of the epitaxial material of the invention. A first epitaxial layer 52 of GaN is grown on sapphire substrate 51. GaN first epitaxial layer 52 grows in a growth direction that is perpendicular to the major surface 59 of sapphire substrate 51. The GaN first epitaxial layer 52 grows generally in the direction indicated by arrow 53. A trench 57, or a plurality of trenches, is formed in GaN first epitaxial layer 52 as shown, preferably by an anisotropic etching method such as reactive ion etching. Trench 57 is defined by side walls 56a and 56b that extend substantially perpendicular from the major surface 63 of GaN first epitaxial layer 52, and by base 58. While side walls 56a and 56b are illustrated herein has having side walls perpendicular to the major surface of GaN first epitaxial layer 52, trench 57 may alternatively have sloped side walls. Side walls 56a and 56b are perpendicular to the major surface of GaN first epitaxial layer 52. Furthermore, while base 58 of trench 57 is depicted as extending partially into GaN first epitaxial layer 52, in some applications, it may be desirable for trench 57 to extend completely through the GaN first epitaxial layer 52 to sapphire substrate 51.

Fig. 2B illustrates continued epitaxial growth in accordance with the invention. Applied over GaN first epitaxial layer 52 is a mask 54. In a preferred embodiment, the material of the mask 54 is silicon dioxide (SiO₂), a dielectric. However, the mask material may alternatively be a conducting material such as tungsten. Mask 54 causes epitaxial growth to occur preferentially on the crystalline surfaces of GaN first epitaxial layer 52 that are not covered by mask 54. Mask 54 is applied both over the top surfaces of GaN first epitaxial layer 52 and also to the base 58 of trench 57. Additionally, mask 54 may be applied to one of the side walls of trench 57.

Mask 54 causes second epitaxial layer 55 to grow laterally from side walls 56a and 56b. In this manner, the growth direction of second epitaxial layer 55 is rotated through 90°, or nearly 90° relative to the conventional growth direction. Because the strain in the second epitaxial layer 55 is parallel to the side wall 56a, cracks 17 will now propagate substantially parallel to the major surface 63 of GaN first epitaxial layer 52. Although omitted from Fig. 2B for clarity, a growth of second epitaxial layer 55 would also initiate from side wall 56b as the mask 54 does not cover the side wall 56b in the example shown. In a preferred embodiment, second epitaxial layer 55 is comprised of AlGaN.

Fig. 2C illustrates the further growth progression of AlGaN second epitaxial layer 55 of Fig. 2B. As shown, AlGaN second epitaxial layer 55 continues growing from side walls 56a and 56b, and eventually grows together, filling, and overflowing trench 57. As stated above, cracks 17 propagate perpendicular to the growth direction of GaN first epitaxial layer 52.

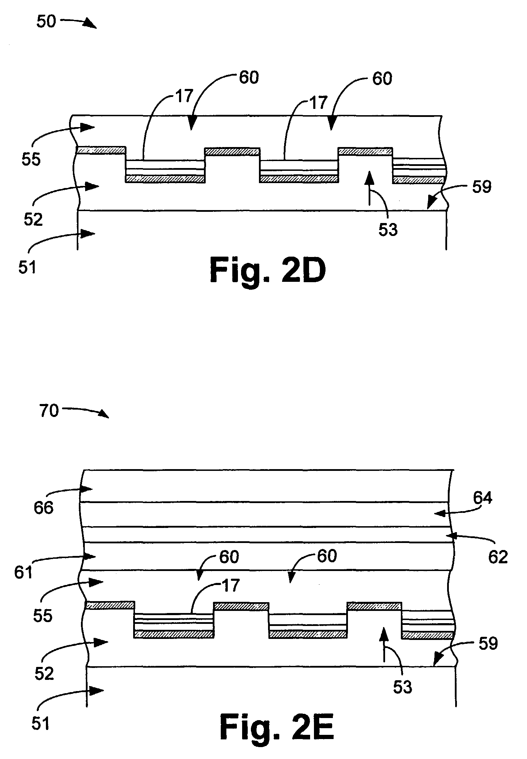

Since the strain in the second epitaxial layer 55 is parallel to the side walls 56a and 56b, formation of the cracks 17 relieve a significant amount of the strain in the portion of the AlGaN second epitaxial layer 55 that is in the vicinity of side walls 56a and 56b. In this manner, as will be described with respect to Fig. 2D, the AlGaN second epitaxial material 55 that grows out of trench 57 will have significantly less strain, and will therefore be substantially crack-free.

Fig. 2D illustrates the crack-free region 60 that forms as the result of further growth of AlGaN second epitaxial layer 55 in accordance with the invention. Continued growth of AlGaN second epitaxial layer 55 causes the layer to grow out of trench 57 to form crack-free region 60. Region 60 in AlGaN layer 55 is crack-free because the cracks 17 are localized substantially within trench 57. In accordance with the invention, and because the initial growth direction and the mismatch strain of AlGaN second epitaxial layer 55 were rotated 90° with respect to the growth of the GaN first epitaxial layer 52, cracks 17 propagate in the direction perpendicular to the growth direction 53 of GaN first epitaxial layer 52. In this manner, crack-free region 60 in AlGaN second epitaxial layer 55 is created, thus providing a stable, crack-free surface for the growth of additional epitaxial layers thereupon.

Fig. 2E illustrates an edge-emitting laser structure 70 including epitaxial layers grown over AlGaN second epitaxial layer 55 of Fig. 2D. As illustrated, cladding layer 61, which comprises AlGaN is grown directly over AlGaN second epitaxial layer 55, which includes substantially crack-free region 60. Over cladding layer 61 is grown active layer 62, which may include multiple quantum wells as known in the art.

Over active layer 62 is grown an additional cladding layer 64. Cladding layer 64 is similar in structure to cladding layer 61. Together, cladding layers 61 and 64 are used to provide optical confinement and carrier (electron and hole) confinement for laser structure 70. Over cladding layer 64 is applied p-type contact material 66.

Only the principal epitaxial layers of laser device 70 have been illustrated herein. Furthermore, either p or n-type material may be used interchangeably, depending on the device structure desired. Laser structure 70 has been provided to illustrate the ability to grow additional epitaxial layers over the crack-free region 60 of AlGaN second epitaxial layer 55. Indeed, the invention is applicable to growing any type of epitaxial material over another type of epitaxial material having a different atomic structure, and therefore a different lattice parameter.

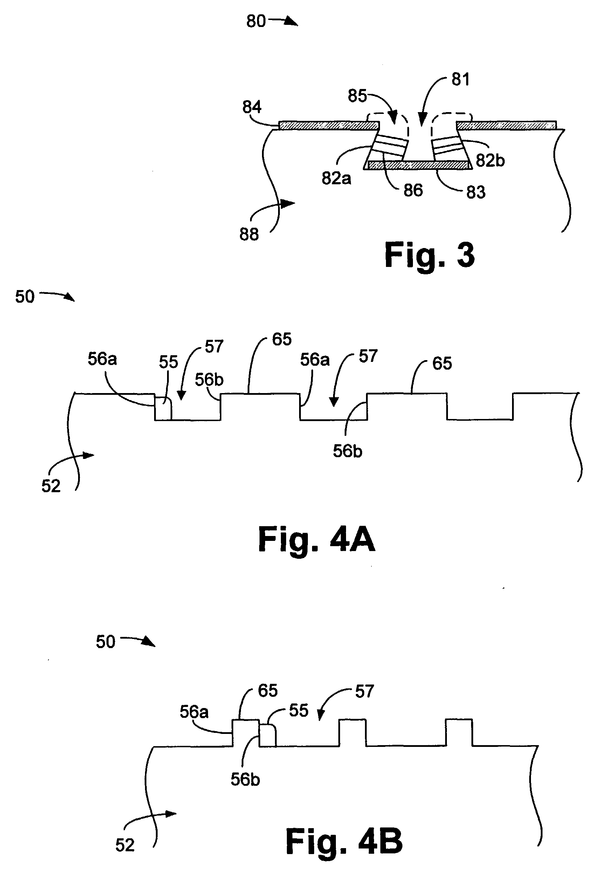

Fig. 3 is a cross-sectional schematic view illustrating an alternative embodiment of the trench 57 of Fig. 2A. Trench 81 is formed in GaN first epitaxial layer 88, preferably by etching as discussed above, such that side walls 82a and 82b form acute angles with respect to base 83 of trench 81. In a similar manner to that described with respect to Figs. 2B, mask 84, which in this embodiment is SiO₂, is applied over GaN first epitaxial layer 88 and the base 83 of trench 81. A second epitaxial layer 85 of AlGaN is then grown laterally from side walls 82a and 82b as indicated in Fig. 3, such that cracks 86 propagate toward the base 83 of trench 81. In this manner, once the growth of AlGaN second epitaxial layer 85 emerges from trench 81 and grows over mask 84, substantially crack-free material as described with respect to Fig. 2D will be formed.

Figs. 4A and 4B are cross-sectional schematic views illustrating alternative trench structures of the epitaxial growth material of Figs. 2A-2D. In Fig. 4A the trenches 57 are roughly the same width as the lands 65 between them. In Fig. 4B, the trenches 57 are substantially wider than the lands 65 between them. The ratio of the widths of the trenches 57 to the lands 65 is not particularly critical to the invention, and the width ratios illustrated in Figs. 4A and 4B are merely examples.

It will be apparent to those skilled in the art that many modifications and variations may be made to the preferred embodiments of the invention, as set forth above, without departing substantially from the principles of the invention. For example, the method for growing epitaxial material having cracks contained laterally within a trench and resultant material can be used to fabricate light emitting diodes and other devices. All such modifications and variations are intended to be included herein within the scope of the invention, as defined in the claims that follow.

## Claims

1. A method for reducing cracks (17) in an epitaxial growth layer (55), the method comprising the steps of:
growing a first epitaxial layer (52) of a first material, said first epitaxial layer (52) having a major surface (63);
forming, in said first material, a surface (56a, 56b) substantially perpendicular to said major surface (63);
applying a mask (54) to said first epitaxial layer major surface (63) leaving said substantially perpendicular surface (56a, 56b) unmasked; and
laterally growing from said substantially perpendicular surface (56a, 56b) a second epitaxial layer (55) of a material different from said first material.

2. The method of claim 1, wherein said substantially perpendicular surface (56a, 56b) is formed by etching a trench (57) in said first epitaxial layer (52).

3. The method of claim 1 or 2, wherein said second epitaxial layer (55) has cracks (17) therein, said cracks (17) extending parallel to said major surface (63) of said first epitaxial layer (52).

4. The method of one of the preceding claims, wherein said second epitaxial layer (55) completely fills and overflows said trench (57).

5. The method of claim 4, wherein the portion (60) of said second epitaxial layer (55) that overflows said french (57) includes substantially fewer cracks (17) than said portion that fills said trench (57).

6. An epitaxial material (50), comprising:
a first epitaxial layer (52) of a first material, said first epitaxial layer (52) having a major surface (63) and including a surface (56a, 56b) substantially perpendicular to said major surface (63);
a mask (54) covering said first epitaxial layer major surface (63), but leaving said substantially perpendicular surface (56a, 56b) exposed; and
a second epitaxial layer (55) of a second material, said second epitaxial layer (55) extending from said substantially perpendicular surface (56a, 56b) of said first epitaxial layer (52) and including cracks (17) that extend parallel to said major surface (63) of said first epitaxial layer (52) and are localized to the vicinity of said substantially perpendicular surface (56a, 56b).

7. The material (50) of claim 6, wherein said substantially perpendicular surface (56a, 56b) of said first epitaxial layer (52) is a side wall (56a, 56b) of a trench (57) within said first epitaxial layer (52).

8. The material (50) of claim 6 or 7, wherein said second epitaxial layer (55) completely fills and overflows said trench (57).

9. The material (50) of claim 8, wherein the portion (60) of said second epitaxial layer (55) that overflows said trench (57) is crack-free.

10. An epitaxial material (50), comprising:
a first epitaxial layer (52) of a first material, said first epitaxial layer (52) having a major surface (63) and including a surface (56a, 56b) substantially perpendicular to said major surface (63); and
a second epitaxial layer (55) of a second material, said second epitaxial layer (55) including a first portion extending laterally from said substantially perpendicular surface (56a, 56b) of said first epitaxial layer (52) and including cracks (17) that extend parallel to said major surface (63) of said first epitaxial layer (52) and are localized to the vicinity of said substantially perpendicular surface (56a, 56b), and a crack-free second portion (60) overlying said first portion of the second epitaxial layer (55).
